# EUROPEAN PATENT SPECIFICATION

(11) **EP 0 470 740 B1**
(45) Date of publication and mention of the grant of the patent: **11.01.1995**
(21) Application number: 91306862.3
(22) Date of filing: 26.07.1991
(51) Int. Cl.: H05K 3/00

(54) **Rigid-flexible printed circuit and process of forming such a circuit**
Starr-flexible Leiterplatte und Verfahren zur Bildung derselben
Plaquette à circuit imprimé et méthode pour la formation de celle-ci

(30) Priority: 09.08.1990 US 565437
(43) Date of publication of application: 12.02.1992
(73) Proprietor: TELEDYNE INDUSTRIES, INC., Los Angeles, CA 90067 (US)
(72) Inventor: McKenney, Darryl J., Milford, New Hampshire 03055 (US); Dixon, Herbert S., Derry, New Hampshire 03038 (US); Millette, Lee J., Hudson, New Hampshire 03051 (US); Caron, A. Roland, Hudson, New Hampshire 03051 (US)
(74) Representative: Brunner, Michael John

(56) References cited:
- EP-A- 0 255 607
- US-A- 4 037 047
- US-A- 4 800 461

## Description

The present invention relates to multi-layer combined rigid and flexible printed circuits having flexible printed circuits extending from a rigid circuit board and more particularly to improvements in the circuits and the process described in our US patent no. 4,800,461. Particularly as described in Figure 5 thereof, a Rigid-Flex® circuit board is shown wherein an epoxy-impregnated fibreglass rigid section (known as prepreg) is provided with an opening spanned by a flexible polyimide which is designed to provide flexible leads extending from the rigid portion of the board.

In producing the basic copper-fibreglass/polyimide laminate, difficulties have been encountered in providing a smooth, ripple-free laminate which can be held accurately in the focal plane of a photo-resist exposure system for providing the precise photo image which is subsequently developed in the overall etching process to produce the fine copper leads.

One aspect of the present invention, as disclosed in claim 1, is directed to an improved process for manufacturing such printed circuit boards where a rigid insulating layer supports one portion of the printed circuit and a flexible insulator supports another portion thereof to furnish flexible leads for connecting the printed circuit to an operative device.

Another aspect of the present invention, as disclosed in claim 5, is directed to an intermediate product in the production of a printed circuit board.

An intermediate product in the production of a printed circuit board is disclosed in EP-A-0255607.

In the improved process of the present invention, a first assembly is provided comprising a partially cured semi-rigid prepreg (preferably fibreglass-epoxy) having an opening for the flexible leads. A flexible insulating sheet, such as a polyimide spans this opening and overlies the edges by a very small amount, of the order of 1.27mm (0.050 inch). This assembly is placed in contact with a deformable pressure transmitting body such as a flowable, curable conformable prepreg or "conformal" to form a sandwich. Preferably, another partially cured windowed fibreglass/polyimide assembly is placed on the other side of the flowable conformal layer. Since the conformal prepreg is only a process element of the sandwich and is not to be incorporated in the final printed circuit, it is provided with release layers on both of it's surfaces to prevent bonding of the major area of conformal to the outer fibreglass prepreg layer. These release layers are preferably smaller in dimension than the conformal and prepreg layers so that the fibreglass epoxy layers extend about an inch (25mm) beyond each edge of the release layers. In a preferred embodiment of the invention, the sandwich is made of two of the fibreglass-prepreg/polyimide sheets, one on each side of the deformable body. This sandwich is then placed between two hard smooth surfaces, such as steel plates, and pressed to partially cure the fibreglass-prepreg and bond the polyimide sheet firmly to the edges of the opening. In the first pressing operation the edges of the prepreg and conformal layers are bonded together, and the conformal layer is made rigid. Release layers are provided between the steel pressing plates and the top and bottom prepreg layers to prevent bonding to the steel plate. These outer release layers are removed before the second pressing operation.

As can be seen from the above brief description of the invention a very important aspect is the provision of a very smooth flat surface to the transition between the rigid-fibreglass and the flexible polyimide by creating the bond between the polyimide and the fibreglass under conditions where the surface to be mounted to the copper is held in contact with a smooth rigid plate and the other, back surface, is supported by a flowable curable member which compensates for the difference in thickness between the fibreglass and the polyimide sheet. In one typical example the fibreglass sheet at the beginning of the pressing operation is 0.076mm - 0.116mm (0.003 - 0.005 inch) thick while the polyimide is only 0.025mm - 0.076mm (0.001 - 0.003 inch) thick.

One example of a circuit and process according to the present invention will now be described with reference to the accompanying drawings, in which:-
Figure 1 is Figure 5 of US-A-4800461;
Figure 2 is as an expanded process diagram showing the arrangement of the various layers in the two pressing steps;
Figure 3 is a diagrammatic schematic drawing showing the sandwich of the two fibreglass-polyimide layers with a filling of conformal situated between two flat rigid pressing plates; and,
Figure 4 is a view similar to Fig. 3 showing the final product with the copper layers being bonded to the product of the first pressing operation.

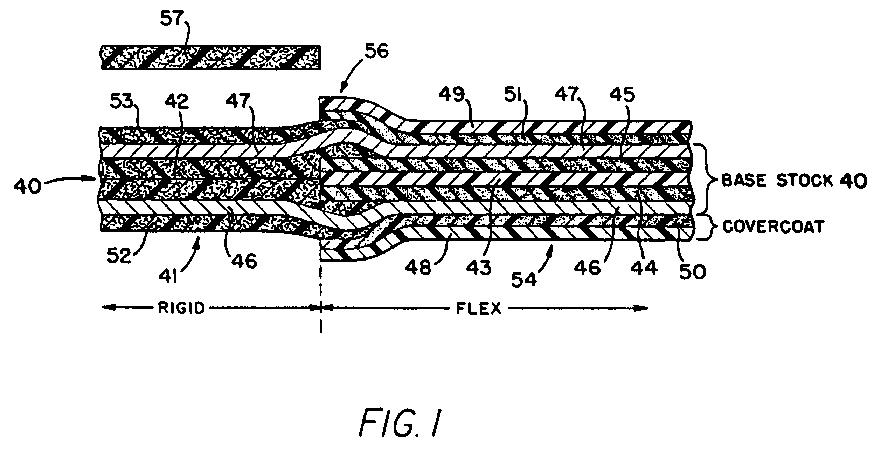

Referring to Fig. 1, generally, the same numbers are used as were used in US-A-4800461.

In the product of Fig. 1 the rigid section comprises a portion 41 having fibreglass epoxy layers 53, 42, 52 and 57 and copper layers 46 and 47. The flexible portion comprises polyimide layers 49, 43, and 48 and acrylic layers 51, 50, 45 and 44. The present invention is particularly directed to the production of a flat smooth transition between the rigid and the flexible portions of the circuit.

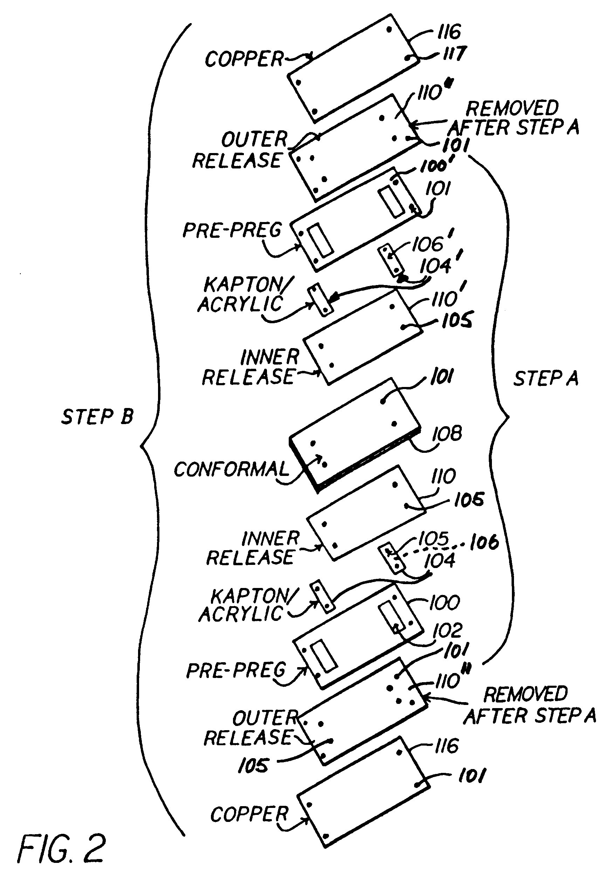

Referring now to Fig. 2, there is shown an exploded view of the various layers to be assembled in the two pressing operations. Step A creates the smooth outer surface of the sandwich and Step B is the second processing step wherein the copper sheets are bonded to the smooth outer surfaces of the sandwich.

In the first pressing operation, the first layer is a bottom prepreg layer 100, on top of which are two smaller polyimide layers 104 of Kapton®, which overly cutouts 102 in the prepreg 100. Locating holes 101 are provided in each layer for precisely aligning the various layers. The locating holes 101 provided in the polyimide sheets 104, are positioned where they will not interfere with the printed circuit design. The surfaces of the polyimide layer 104 to be placed adjacent the prepreg 100 each have a layer of acrylic adhesive 106. On top of the first prepreg/polyimide layer is provided a sheet 110 of a release material such as Teflon® to provide a first inner release layer, which is sufficiently smaller than the prepreg layer 100 so that a space about 25mm (one inch) in width exists around the whole of the outer edge of the release layer 110. Next is provided a pair of conformal layers 108 which has the same approximate dimensions as the prepreg layer 100. Thus edge portions of the prepreg layer 100 and the conformal layer 108 abut each other without any intervening release layer. Next is a second inner release layer 110′, further polyimide layers 104′ and a second prepreg layer 100′. On the outsides of the two prepreg layers 100,100′ are provided additional release layers 110˝ which prevent adhesion of the prepreg layers 100,100′ to the pressing plates.

The polyimide layers 104,104′ can be temporarily bonded to the release layer by localized application of heat and pressure around holes 105 to prevent lateral slippage of the polyimide with respect to the semi-rigid epoxy fibreglass layers 100,100′ when assembling the sandwich for the first pressing operation.

The first pressing operation partially cures the prepregs 100,100′ and the conformals 108, and bonds all the curable layers together at their edges by pressing between a pair of steel sheets (not shown) to form a relatively rigid sandwich. The press is then opened, the outer release sheets 110˝ are removed and copper sheets 116,116′ are positioned in the press by use of locating holes 117 and the pressing operation is continued at a higher temperature to bond the two copper layers firmly to the outer surfaces of the sandwich. Thereafter the two steel sheets are moved apart. The product can then be coated with a photo-resist and exposed to the necessary circuit diagram, the smooth copper surface lying in a single plane for accurate photo exposure. This exposure is preferably accomplished before disassembling the sandwich. The copper will have a smooth surface, since it was bonded in a ripple-free fashion, and can be held in a flat focal/plane.

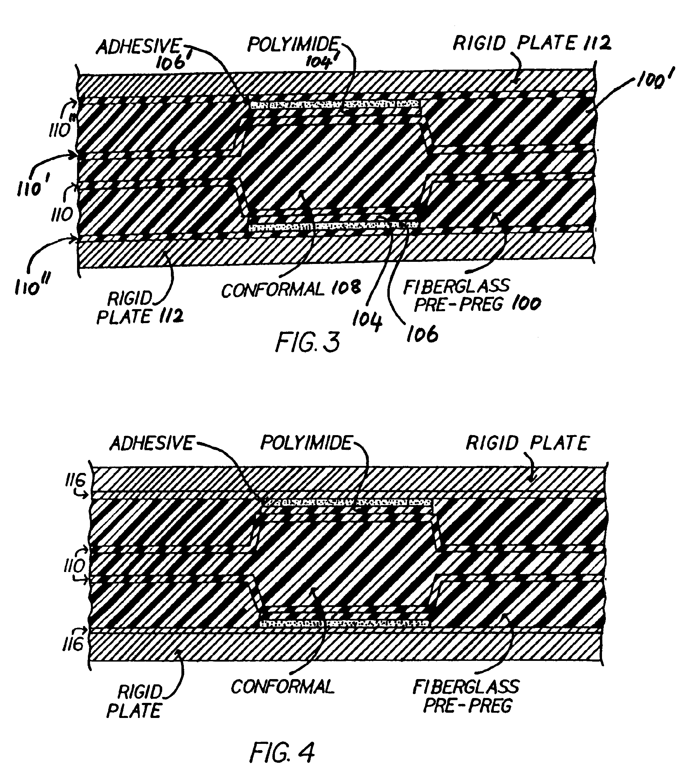

Referring now to Figs. 3 and 4, there is shown the sandwich assembly comprising the preferred form of invention. There is first provided a sheet of fibreglass-epoxy prepreg 100 which is provided with an opening 102. Spanning the opening is a layer of polyimide 104 which overlaps the opening by approximately 1.27mm (0.050 inches). The outer surface of the polyimide is provided with a layer of acrylic adhesive 106. Behind the composite polyimide/fibreglass layer is a release layer 110 and then a conformal layer 108 which preferably is a flowable, curable fibreglass epoxy prepreg. The structure then follows the same order on the other side of the conformal 108. A pair of outer release layers 110˝ are provided. The purpose of the conformal is to fill in the space behind the polyimide film so as to compensate for the thinner polyimide sheet to force the upper surface of the polyimide sheet into conformance with a smooth surface of rigid plates 112.

During the first pressing operation both the fibreglass prepreg and the conformal prepreg are partially cured so that they retain the shape obtained in the first pressing. After the first pressing step the outer two release coats 110˝ are removed and replaced by two layers of copper 116 (see figure 4). Since the sandwich edges are sealed together, the various layer of the sandwich, comprising fibreglass-polyimide-conformal, remain as a relatively stiff unit. Pressing is then continued to bond the copper layers 116 to the outer surfaces of the sandwich. As mentioned, the two slightly smaller layers 110,110′ of Teflon are provided, one on each side of the conformal, to prevent adhesion of the major portions of conformal to the outer layers of the sandwich so that the conformal can eventually be removed from the sandwich.

As mentioned, it is also preferred that adhesion between the rigid plates 112 and the fibreglass-polyimide acrylic system be prevented by use of release sheets 110˝ in the first pressing Step A.

In the preferred embodiment of the invention the following materials are combined under the detailed specified conditions.

### EXAMPLE I

Fibreglass epoxy "No Flow" layers 100,100′ are system "1080", in accordance with MIL-P13949, and are initially of the order of 0.076mm - 0.116mm (0.003 - 0.005 inches) thick.

Polyimide layers 104,104′ are preferably 0.025mm - 0.076mm (0.001 - 0.003 inch) thick DuPont Kapton®.

Acrylic adhesive 106 is on the order of 0.025mm - 0.076mm (0.001 - 0.003 inch) thick and is designated JW 712.

Teflon® release sheets 110,110′ are preferably DuPont "superclean" grade TMR3, 0.025mm (0.001 inch) thick.

Conformal prepreg 108 is preferably formed of two layers of fibreglass epoxy 1080 in accordance with the same specs as the fibreglass prepreg except that it is designated "High Flow" rather than "No Flow". This permits the product of layer 108 to flow into the space adjacent the back of the polyimide sheet to permit creation of a smooth front surface.

Copper sheets 116 are preferably IPC-CF-150 Type WRA. They are 0.107mm - 0.0174mm (0.0042 inch - .00075 inch, that is 3 ounce to 1/2 ounce), depending on the circuit requirements.

The first pressing operation is conducted at 1.489 x 10⁶N.m⁻² (216 psi), and 127°C (250°F) for 30 minutes.

The second pressing operation is carried out at the same pressure at 150°C - 182°C (300 - 360°F) for 60 minutes. After the resulting sandwich, with the copper on the outside, is removed from the press it is then treated in accordance with normal printed circuit technology. For example, it can be pumice cleaned. Photo-resist is then applied, the resist is exposed on both sides, the pattern is developed, the product is etched and optionally the copper is provided with a black oxide. Thereafter, the sealed "picture frame" edges are then cut and discarded to permit separation of the inner layers to remove the conformal layer and to provide a pair of rigid-flexible printed circuits.

The product resulting from development of a photo-resist - etch circuit on the copper surface can be combined with other circuit elements as described in more detail in US-A-4800461.

While a preferred form of the invention has been described above, numerous other curable and flexible insulating layers may be employed.

## Claims

1. A process for manufacturing a rigid-flexible printed circuit wherein a rigid insulating layer (100,100′) supports one portion of the printed circuit and a flexible insulator (104,104′) supports another portion thereof to furnish flexible leads for connection of the printed circuit to an operative device, comprising the steps of
providing an assembly comprising a partially cured, semi-rigid prepreg insulator layer (100,100′) having an opening (102) for the flexible leads;
providing a flexible sheet (104,104′) spanning the opening;
pressing the assembly with one surface in contact with a smooth hard surface (112) while the other surface is supported against a flowable curable conformable prepreg layer (108), and separated therefrom over a major part by a release layer (110,110′) which prevents bonding between the prepreg layers, while permitting bonding along the edges;
holding the assembly under heat and pressure to cure both prepreg layers partially, to bond the flexible sheet to the edges of the opening and to bond the edges of said prepregs together to form a flat rigid sandwich;
bonding a sheet of copper (116) to the surface previously in contact with the hard surface, in a second pressing operation under conditions to bond the copper to both the partially cured, semi-rigid prepreg insulator layer (100,100′) and the flexible sheet (104,104′); and,
thereafter severing the bonded edges of the cured prepreg layers to permit separation thereof to provide a printed circuit board having rigid and flexible portions.

2. A process according to claim 1, wherein a sandwich is made of two partially cured, semi-rigid prepreg insulator layers (100,100′) and two flexible sheets (104,104′) on opposite sides of the flowable curable conformable prepreg layer (108).

3. A process according to claim 2, wherein release sheets (110,110′) are provided on both sides of the flowable curable conformable prepreg layer (108).

4. A process according to claim 3, including the additional steps of creating and exposing a photo resist on the outer surfaces of the sealed sandwich before separating the layers.

5. An intermediate product in the production of a printed circuit board having rigid and flexible portions comprising a smooth flat layer of copper (116) bonded to a first, rigid fibreglass epoxy prepreg layer (100,100′) having a cutout portion (102), the cutout portion being spanned by a polyamide flexible layer (104,104′) which is adhesively bonded to the copper layers (116), characterised in that it also comprises a release layer and a second continuous flowable conformable prepreg layer of rigid fibreglass epoxy resin (108), compensating for the difference in thickness between said first prepreg layer (100,100′) and flexible layer (104,104′), said release layer preventing bonding between the first and second prepreg layers, the second rigid prepreg layer being bonded around its edges to the first epoxy fibreglass prepreg layer, the release layer being smaller than the epoxy fibreglass layers.

## Patentansprüche

1. Verfahren zur Herstellung einer starr-flexiblen Leiterplatte, wobei eine starre Isolierschicht (100,100′) einen Abschnitt der Leiterplatte trägt und eine flexible Isolierschicht (104, 104′) einen anderen Abschnitt derselben, um flexible Leitungen für den Anschluß der Leiterplatte an ein Arbeitsgerät bereitzustellen, und wobei das Verfahren die folgenden Schritte umfaßt:
Schaffung einer Anordnung mit einer teilweise ausgehärteten, halbstarren Prepreg-Isolierschicht (100, 100′) mit einer Öffnung (102) für die flexiblen Leitungen;
Schaffung einer die Öffnung überspannenden flexiblen Folie (104, 104′);
Zusammenpressen der Anordnung, wobei eine Seite mit einer glatten, harten Oberfläche (112) in Kontakt steht, während die andere Seite an einer fließfähigen, aushärtbaren, formanpassungsfähigen Prepregschicht (108) anliegt und von derselben größtenteils durch eine Trennschicht (110, 110′) getrennt wird, welche das Zusammenkleben zwischen den Prepregschichten verhindert, während sie ein Verkleben entlang der Kanten ermöglicht;
das Behandeln der Anordnung unter Wärme und Druck, um beide Prepregschichten teilweise auszuhärten, die flexible Platte an den Rändern der Öffnung zu verkleben und die Kanten der Prepregs miteinander zu einer flachen, starren Schichtanordnung zu verkleben;
das Ankleben einer Kupferplatte (116) an die Fläche, die zuvor an der harten Oberfläche anlag, während eines zweiten Preßvorgangs, bei dem das Kupfer sowohl auf die teilweise ausgehärtete, halbstarre Prepreg-Isolierschicht (100, 100′) als auch auf die flexible Folie (104, 104′) aufgeklebt wird; und
anschließend das Abtrennen der verklebten Kanten der ausgehärteten Prepregschichten, um das Loslösen von ihnen zu ermöglichen und somit eine Leiterplatte mit starren und flexiblen Abschnitten zu schaffen.

2. Verfahren nach Anspruch 1, wobei eine Schichtanordnung aus zwei teilweise ausgehärteten, halbstarren Prepreg-lsolierschichten (100, 100′) und zwei flexiblen Folien (104, 104′) auf den gegenüberliegenden Seiten der fließfähigen, aushärtbaren, formanpassungsfähigen Prepregschicht (108) ausgebildet wird.

3. Verfahren nach Anspruch 2, wobei Trennschichten (110,110′) auf beiden Seiten der fließfähigen, aushärtbaren, formanpassungsfähigen Prepregschicht (108) vorgesehen sind.

4. Verfahren nach Anspruch 3 mit den zusätzlichen Schritten der Schaffung und Belichtung eines Fotoresists auf den Außenflächen der geschlossenen Schichtanordnung vor dem Trennen der Schichten.

5. Ein Zwischenprodukt bei der Herstellung einer Leiterplatte mit starren und flexiblen Abschnitten, welches umfaßt: eine glatte, flache Kupferschicht (116), die auf eine erste starre Glasfaser-Epoxid-Prepregschicht (100, 100′) mit einem Ausschnitt (102) aufgeklebt ist, wobei der Ausschnitt von einer flexiblen Polyamidschicht (104, 104′) überspannt wird, die mit den Kupferschichten (116) verklebt ist, dadurch gekennzeichnet, daß es weiterhin eine Trennschicht sowie eine zweite durchgehende, fließfähige, formanpassungsfähige Prepregschicht aus Glasfaser-Epoxidharz (108) umfaßt, die den Dickenunterschied zwischen der ersten Prepregschicht (100, 100′) und der flexiblen Schicht (104, 104′) ausgleicht, wobei die Trennschicht das Zusammenkleben zwischen der ersten und der zweiten Prepregschicht verhindert, die zweite starre Prepregschicht um ihre Kanten herum mit der ersten Epoxy-Glasfaser-Prepregschicht verklebt wird und die Trennschicht kleiner als die Epoxy-Glasfaserschichten ist.

## Revendications

1. Procédé pour la fabrication d'un circuit imprimé rigide souple dans lequel une couche isolante rigide (100, 100′) supporte une portion du circuit imprimé, et un isolateur souple (104, 104′) supporte une autre portion de celui-ci pour fournir des conducteurs souples pour la connexion du circuit imprimé sur un dispositif opérant, comprenant les étapes consistant à :
fournir un ensemble comprenant une couche d'isolateur en préimprégné partiellement durci, semi-rigide (110, 110′) avec une ouverture (102) pour les conducteurs souples ;
fournir une feuille souple (104, 104′) recouvrant l'ouverture ;
comprimer l'ensemble avec une surface en contact avec une surface dure lisse (112) tandis que l'autre surface est supportée en opposition à une couche de préimprégné conformable durcissable et coulable (108) et, séparée sur une grande partie par une couche de séparation (110, 110′) qui empêche le soudage entre les couches de préimprégné tout en permettant le soudage le long des bords ;
maintenir l'ensemble sous la chaleur et la pression pour durcir les deux couches de préimprégné partiellement et souder la feuille souple sur les bords de l'ouverture et souder les bords des couches de préimprégné conjointement pour former un sandwich rigide plat ;
souder une feuille de cuivre (116) à la surface préalablement en contact avec la surface dure, dans une seconde opération de compression dans des conditions pour souder le cuivre à la fois sur la couche d'isolateur préimprégné semi-rigide durci partiellement et sur la couche souple (104, 104′) ; et,
séparer les bords soudés des couches de préimprégné durci pour permettre leur séparation et fournir une plaquette de circuit imprimé comportant des portions rigides et souples.

2. Procédé selon la revendication 1, dans lequel l'ensemble en sandwich est réalisé à partir de deux couches de préimprégné isolantes , semi-rigides, durcis partiellement (100, 100′) et de deux feuilles souples (104, 104′) sur les côtés opposés de la couche de préimprégné coulable, durcissable, conformable (108).

3. Procédé selon la revendication 2, dans lequel les feuilles de libération (110, 110′) sont prévues des deux côtés de la couche de préimprégné coulable, durcissable, conformable (108).

4. Procédé selon la revendication 3, comprenant les étapes supplémentaires consistant à créer et à exposer une photo-réserve sur les surfaces extérieures de l'ensemble en sandwich scellées avant la séparation des couches.

5. Produit intermédiaire dans la production d'une plaquette de circuit imprégné avec des portions rigides et souples comprenant une couche plate lisse de cuivre (116), soudée sur une première couche de préimprégné époxyde-fibre de verre rigide (100, 100′) avec une portion de découpe (102), la portion de découpe étant revêtue d'une couche souple de polyimide (104, 104′) qui est soudée de façon adhésive sur les couches de cuivre (116) caractérisé en ce qu'il comprend également une couche de séparation, une seconde couche continue, coulable, conformable de préimprégné, de résine époxyde-fibre de verre (108) cette couche de séparation empêchant le soudage entre les premières et secondes couches de préimprégné, la seconde couche de préimprégné rigide étant soudée autour de ses bords sur la première couche de préimprégné en fibre de verre-époxyde, la couche de séparation étant plus petite que les couches de fibre de verre-époxyde.
